Europäisches Patentamt

**European Patent Office**

**Office européen des brevets**

(19)

(11) Numéro de publication: **0 124 412**

**B1**

(12)

# FASCICULE DE BREVET EUROPÉEN

(45) Date de publication du fascicule du brevet:
08.04.87

(21) Numéro de dépôt: **84400745.0**

(22) Date de dépôt: **13.04.84**

(51) Int. Cl.⁴: **H 01 B 13/00,** H 05 K 13/06

(54) **Système pour la réalisation de pièces de câblage électrique.**

(30) Priorité: **27.04.83 FR 8306903**

(43) Date de publication de la demande:
**07.11.84 Bulletin 84/45**

(45) Mention de la délivrance du brevet:
**08.04.87 Bulletin 87/15**

(84) Etats contractants désignés:
**DE GB IT NL**

(56) Documents cité:
**AU-B-458 241**
**DE-A-2 118 545**
**FR-A-2 428 897**
**US-A-3 706 134**

(73) Titulaire: **AEROSPATIALE Société Nationale
Industrielle, 37 boulevard de Montmorency,
F-75781 Paris Cédex 16 (FR)**

(72) Inventeur: **Jonca, Henri Valentin Jean, 38 Bld
Bruhnes, F-31300 Toulouse (FR)**

(74) Mandataire: **Bonnetat, Christian, Cabinet PROPI
Conseils 23 rue de Léningrad, F-75008 Paris (FR)**

EP 0 124 412 B1

LIBER, STOCKHOLM 1987

## Description

La présente invention concerne un système pour la réalisation de pièces de câblage, apportant une aide au branchement et à la réalisation du cheminement de chacun des conducteurs électriques de telles pièces.

On sait que le câblage total d'une installation électrique, par exemple l'installation électrique de bord d'un aéronef, est subdivisé en une pluralité de pièces de câblage, réalisées séparément et ensuite reliées les unes aux autres. A l'intérieur de chacune desdites pièces de câblage, chaque conducteur ou câble est identifié par un code; de plus, chacune des deux extrémités d'un conducteur est identifiée par une adresse, qui correspond à son emplacement de connexion à l'intérieur du dispositif de raccordement (connecteur ou équipement) auquel cette extrémité doit être reliée, et le cheminement du conducteur à l'intérieur de ladite pièce de câblage, entre ses deux extrémités, est l'objet d'indications codées.

Ces différentes informations d'adresse et de cheminement, concernant les différents conducteurs des différentes pièces de câblage, sont élaborées et traitées lors de la conception du câblage et sont, dans le cas d'une installation complexe, généralement stockées sur des mémoires de masse, telles que disques souples ou disques durs, susceptibles d'être mises en liaison avec un calculateur électronique. Un calculateur peut donc délivrer, en fonction des besoins, des supports de papier sur lesquels sont imprimées les informations concernant lesdites pièces de câblage.

Par les documents DE-A-2 118 545 et AU-B-458 241, on connaît déjà un système destiné à la réalisation de pièces de câblage électrique, dans lesquelles chaque conducteur relie deux dispositifs de raccordement dont chaque emplacement de connexion d'au moins l'un d'eux est transparent, et comportant un calculateur associé à une mémoire de masse dans laquelle sont emmagasinées des informations concernant l'identification des conducteurs, les adresses des extrémités de ceux-ci, ainsi que le cheminement de chacun desdits conducteurs, ledit système comportant au moins un poste de travail pour un opérateur, en liaison avec ledit calculateur et avec ladite mémoire de masse, et ledit poste de travail comportant des moyens d'introduction de données et un ensemble de points lumineux commandables sélectivement et disposés selon une répartition semblable à celle desdits emplacements de connexion transparents dudit dispositif de raccordement, chaque poste de travail comportant des moyens d'affichage.

On remarquera que, pour réaliser de telles pièces de câblage, il est nécessaire que l'opérateur reçoive non seulement des informations sur les emplacements de connexion des extrémités des conducteurs sur les connecteurs, mais encore des informations concernant le cheminement de chaque conducteur à l'intérieur de ces pièces de câblage.

En effet, si l'opérateur commet une erreur en ce qui concerne la longueur et la mise en forme d'un conducteur à l'intérieur de la pièce de câblage, c'est-à-dire si le cheminement exact dudit conducteur n'est pas respecté, cette pièce n'est pas utilisable et doit être mise au rebut.

Aussi, l'objet de la présente invention est un système du type mentionné ci-dessus, susceptible de permettre d'éviter cet inconvénient et de faciliter la tâche de l'opérateur.

A cette fin, selon l'invention, le système du type mentionné ci-dessus est caractérisé en ce que les moyens d'introduction de données, l'ensemble de points lumineux commandables, le dispositif de raccordement à connecter et lesdits moyens d'affichage sont solidaires d'un organe mobile pouvant se déplacer le long d'au moins un ratelier pourvu d'encoches pour les conducteurs de la pièce de câblage et supporté par le bâti dudit poste de travail.

Ainsi, le calculateur peut indiquer à l'opérateur, par l'intermédiaire desdits moyens d'affichage, le cheminement de chacun desdits conducteurs, de sorte que celui-ci, par déplacement dudit organe mobile, par le choix de ratelier et par le choix d'une encoche dans le ratelier dans laquelle il introduit ledit câble, peut réserver, pour chaque conducteur, la longueur suffisante qui sera nécessaire à l'obtention du cheminement définitif et préformer la partie de la pièce de câblage proche dudit organe de raccordement en correspondance avec ledit cheminement définitif.

Les moyens d'introduction de données peuvent être de tout type connu, tel que clavier alphanumérique ou lecteurs optiques: ils ont pour objet d'introduire dans le système les codes d'un conducteur à connecter et du dispositif de raccordement à emplacements de connexion transparents.

Ainsi, lorsque par l'intermédiaire desdits moyens d'introduction de données, le calculateur connaît les codes d'un câble à connecter et du dispositif de raccordement, il peut faire s'allumer le point lumineux commandable correspondant. Si le dispositif de raccordement est alors appliqué contre ledit ensemble des points lumineux commandables, l'adresse du conducteur à brancher apparaît donc par éclairage.

Ainsi, le système selon l'invention permet le repérage physique (sous forme d'éclairage d'adresse) sans que l'opérateur ait à rechercher des repères sur le dispositif de raccordement à brancher pour procéder, par exemple, à l'insertion de l'extrémité du conducteur à relier. On voit donc qu'ainsi, on réduit les erreurs et le temps de branchement, de sorte que le système selon l'invention minimise les coûts et la durée de la réalisation d'une pièce de câblage.

Pour que l'éclairage d'adresse puisse être mis en oeuvre simplement, il est bon que les emplacements de connexion du dispositif de raccordement soient transparents, c'est-à-dire, littéralement, se laissent aisément traverser par la lumière. Il en est notamment ainsi lorsque le dispositif de raccordement comporte un socle percé d'un trou traversant à chacun desdits emplacements de connexion, la liaison entre le dispositif de raccordement et un conducteur s'effectuant par encliquetage d'une douille dans un tel trou, cette douille étant préalablement sertie à l'extrémité dudit conducteur.

Il existe de nombreuses formes et tailles de dispositif de raccordement de ce type. Aussi, pour éviter d'avoir à modifier les liaisons et les commandes entre le calculateur et l'ensemble des points lumineux commandables en fonction du dispositif de raccordement à brancher, il est avantageux, quel que soit le modèle du dispositif de raccordement, que le système selon l'invention comporte une matrice unique de points lumineux commandables et une pluralité de faisceaux de fibres optiques interchangeables, chacun desdits faisceaux étant adapté à un modèle particulier de dispositif de raccordement et étant composé de fibres optiques, qui, à une de leurs extremites, se trouvent en regard d'au moins certains desdits points lumineux commandables et, à leur autre extrémité, se trouvent en regard des emplacements de connexion transparents dudit modèle particulier du dispositif de raccordement, auquel il est adapté, et que chacun desdits faisceaux de fibres optiques soit monté, en vue de la facilité de son interchangeabilité avec les autres, dans un organe amovible présentant la forme d'un tiroir pouvant être mis en place dans l'organe mobile et sorti de celui-ci, par simple coulissement.

Ainsi, un tel faisceau de fibres optiques joue le rôle d'interface spécifique entre la matrice immuable et le dispositif de raccordement.

Pour pouvoir connaître rapidement l'adresse de l'extrémité non encore branchée d'un conducteur dont l'autre extrémité est déjà reliée à un dispositif de raccordement, il est avantageux que chaque poste de travail comporte de plus au moins un organe de connexion qui, d'une part, est susceptible d'être réuni à un dispositif de raccordement auquel sont déjà reliées les extrémités de certains conducteurs, et, d'autre part, est en liaison avec un dispositif de détection susceptible d'indiquer au calculateur celui desdits conducteurs de la pièce de câblage dont l'extrémité opposée au dispositif de raccordement est touchée par l'opérateur. Ainsi, le calculateur peut indiquer directement sur les moyens d'affichage du poste de travail, l'adresse de l'extrémité du conducteur touchée par l'opérateur. Pour tenir compte de la diversité des modèles de dispositifs de raccordement, on prévoit une pluralité de faisceaux d'outillage, susceptibles d'être interposés entre ledit dispositif de raccordement d'une pièce de câblage et ledit organe de connexion.

Là encore, chaque faisceau d'outillage joue le rôle d'interface spécifique entre un dispositif de raccordement et l'organe de connexion.

Dans un mode de réalisation avantageux, ledit dispositif de détection comporte une matrice de points commandables pouvant prendre au moins deux états électriques différents et chacun en liaison un conducteur, un dispositif d'exploration de l'état desdits points commandables de ladite matrice et un dispositif de commande dudit dispositif d'exploration.

Ladite matrice peut être du type à coupleurs optiques, tandis que le dispositif d'exploration peut comporter un multivibrateur astable.

On voit qu'ainsi le système conforme à l'invention introduit une nouvelle méthode de câblage des ensembles électriques en s'adaptant à la gestion informatique de leur préparation et en utilisant des techniques très élaborées comme la lecturs optique ou les touches à effleurement.

A partir d'un fichier central existant, sur les mémoires de masse et grâce à un programme informatique approprié, l'opérateur peut accéder à la pièce de câblage qu'il veut réaliser et faire transférer dans sa zone de travail tous les éléments de ladite pièce qu'il veut connecter ou cheminer. Le transfert étant réalisé, il s'ensuit un message (sonnerie, vogant...) qui avertit l'opérateur que son poste de travail est prêt. Des lors, il a accès aux informations de branchement ou de cheminement à partir de différentes possibilités:

a) si le conducteur est repéré, mais pas encore connecté sur un quelconque élément (prise, barrette), l'opérateur introduit le repère de ce conducteur à l'aide du clavier alpha-numérique et l'information du calculataur en retour se traduit par l'allumage, au moyen de la matrice de royants et par l'intermédiaire des fibres optiques, de la borne à brancher.

Bien entendu, comme il a été noté ci-dessus, l'information, au lieu d'être introduite à l'aide du clavier alpha-numérique, peut l'être au moyen de lecteurs optiques (code barre, matrice de points...). Le conducteur étant alord connecté à l'une de ses extrémités, l'opérateur peut, s'il le désire, connaître la destination de l'autre extrémité par un message s'inscrivant en clair (affichage alpha-numérique) par manipulation du clavier.

b) Si le conducteur est déjà connecté sur un quelconque élément, l'opérateur peut au moyen du système de touches sensitives et en reliant électriquement l'extrémité déjà branchée sur le poste de travail, connaître la destination de l'autre extrémité de chaque câble. Cette possibilité de repérage est beaucoup plus rapide que la correspondante décrite-sous a).

c) Si le conducteur n'est ni branché, ni repéré, l'opérateur peut au moyen d'une séquence préprogrammée connecter et cheminer une série de câbles devant être montés sur la pièce, au moyen d'un magasin de rangement des câbles (orgue) qui est connu et identifiable par le système. A cette fin, chaque poste de travail comporte de plus un magasin divisé en une pluralité de cases dont chacune est identifiable par le calculateur et contient un conducteur non identifié.

d) En outre, l'opérateur peut par simple manipulation du clavier alpha-numérique obtenir toute sorte de renseignements relatifs à la pièce qu'il est en train d'élaborer.

Ainsi, le système conforme à l'invention comprend un ensemble de postes de travail sur lesquels sont montés les différents organes de saisie et de restitution de l'information. Ces postes peuvent être reliés par des systèmes de liaison parallèles ou par des boucles synchrones ou asynchrones à l'ordinateur central, gérant des mémoires de masse et des interfaces de commande associés.

Chaque poste de travail peut être doté de microprocesseurs et être de ce fait autonome par rapport au système central. La conception du dispositif et la disposition des éléments le constituant sont fonction des besoins d'utilisation.

e) On remarquera que le système selon l'invention peut fonctionner en mode semi-automatique, selon lequel l'opérateur introduit le numéro d'une borne à l'aide du clavier; toutefois, il est préférable d'utiliser le mode automatique dans lequel le calculateur central pilote entièrement la machine.

Les figures du dessin annexé feront bien comprendre comment l'invention peut être réalisée. Sur ces figures, des références identiques désignent des éléments semblables.

La figure 1 donne le schéma synoptique général du système de câblage conforme à l'invention.

La figure 2 montre en perspective un mode de réalisation de poste de travail pour le système de la figure 1.

La figure 3 est une coupe selon la ligne III-III de la figure 2, illustrant schématiquement la structure d'un tiroir et de son chariot-réceptacle.

La figure 4 est une coupe schématique longitudinale à travers une prise à brancher.

La figure 5 montre en perspective, vue de l'avant, une prise en cours de câblage.

La figure 6 illustre schématiquement le dispositif de reconnaissance d'adresse de l'extrémité non branchée d'un câble dont l'autre extrémité est déjà branchée.

La figure 7 donne le schéma synoptique d'une partie du dispositif de la figure 6.

La figure 8 illustre le fonctionnement de la matrice de coupleurs optoélectroniques.

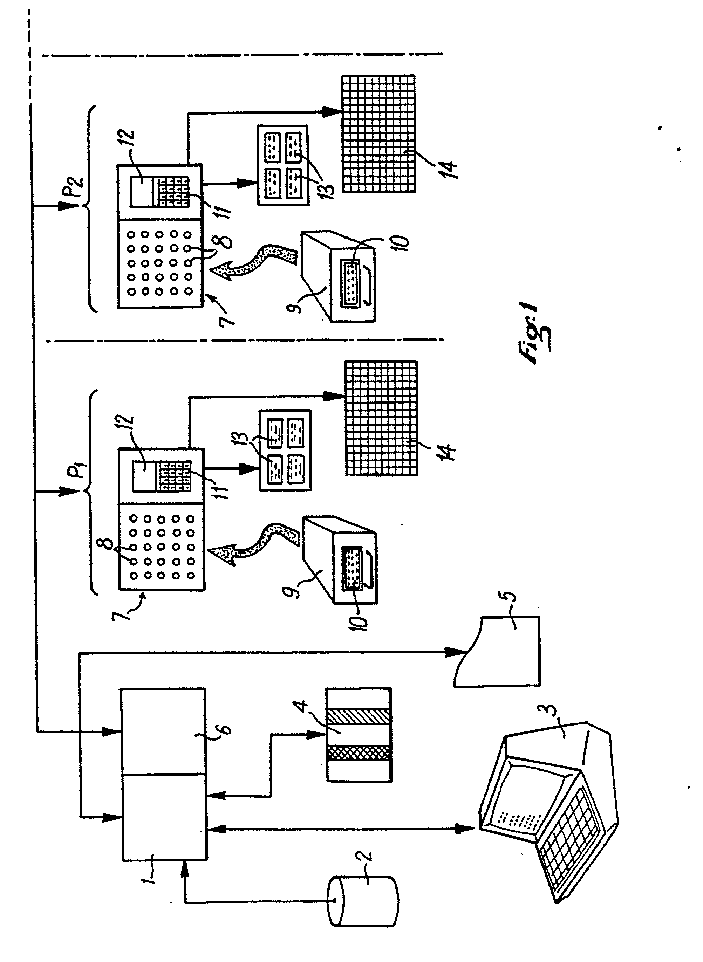

Le système pour la réalisation de pièces de câblage, montré schématiquement par la figure 1 et conforme à l'invention, comporte un calculateur central 1, en liaison avec:

- un disque de grande capacité 2, servant de mémoire de masse dans laquelle sont stockées les informations de travail (données) et les programmes d'opérateur;

- une console vidéo 3 permettant le lancement des programmes et le chargement des données dans la mémoire de masse 2;

- un lecteur de disque souple 4 capable d'être utilisé comme mémoire de masse dans certains cas et comme organe de transfert des données vers le disque dur de la mémoire 2;

- une imprimante rapide 5 permettant d'obtenir un journal d'exploitation;

- un dispositif d'interface spécialisé 6 permettant de relier différents postes de travail $P_1$, $P_2$,...$P_i$... avec le calculateur 1 et vers les divers postes de travail $P_i$ accordés audit calculateur central.

Chacun desdits postes de travail $P_i$, relié par le dispositif d'interface spécialisé 6 au calculateur central 1, comporte:

- une matrice 7 de voyants lumineux 8, chacun desdits voyants pouvant être allumé et éteint indépendamment des autres sur commande du calculateur central 1;

- un organe mobile 9 tel qu'un tiroir, qui porte un élément de raccordement 10 à relier à des conducteurs 23 et qui est spécifique de cet élément 10, ledit tiroir faisant fonction d'interface spécialisée entre la matrice 7 des voyants lumineux 8 et ledit élément 10 de la façon décrite ci-après;

- un clavier alpha-numérique 11 permettant l'introduction des différents repères d'identification des éléments à brancher (câbles, prises, barrettes, etc...) et la réalisation d'un dialogue opérateur avec le calculateur 1;

- un système d'affichage alpha-numérique 12 permettant au calculateur 1 d'adresser à l'operateur differentes opérations et, notamment, de le renseigner en clair sur les différentes destinations des éléments à brancher;

- un ensemble de connecteurs 13 susceptibles de réaliser la liaison électrique d'une pièce de câblage avec le calculateur, via le poste de travail, et permettant de traiter les éléments déjà connectés par simple effleurement de l'extrémité libre du câble (touche sensitive), de la façon décrite ci-après;

- et, éventuellement, un magasin de rangement de câbles 14 pour des câbles non repérés.

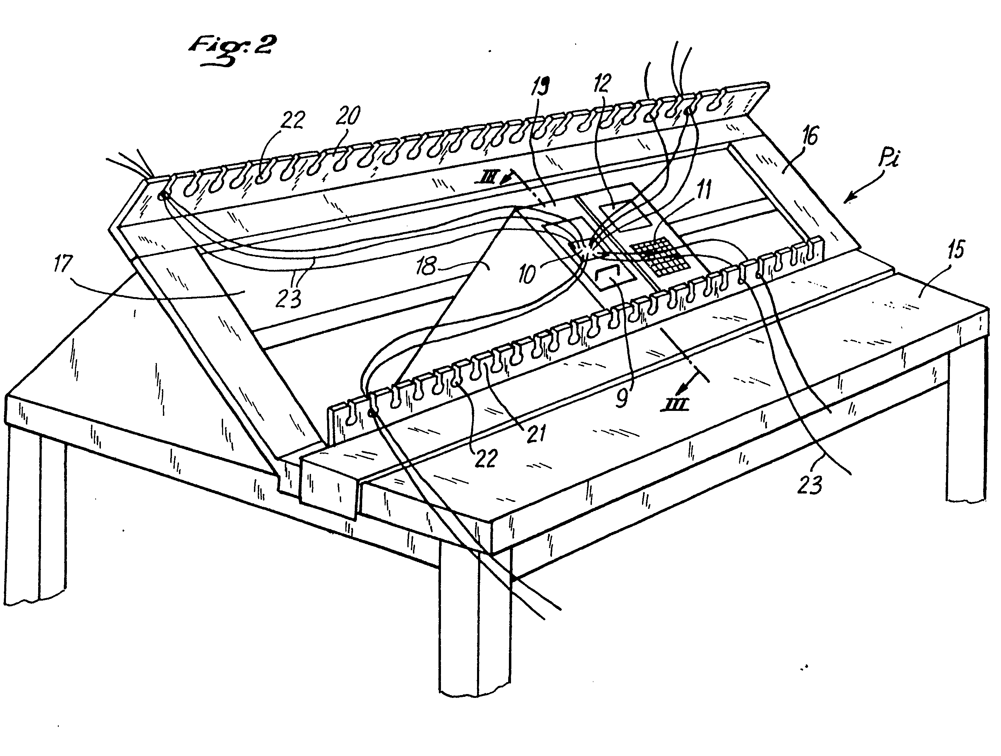

Comme le montre la figure 2, chaque poste de travail $P_i$ comporte un bâti 15, par exemple du type table, devant lequel peut se placer un opérateur. Le bâti 15 porte un pupitre 16, pourvu d'une large ouverture 17, à travers laquelle est accessible un chariot 18, en forme de caisson, pouvant coulisser, grâce à des moyens non représentés, d'un côté à l'autre du bâti 15. Le chariot 18 est incliné de façon que sa face avant 19 se présente au mieux devant l'opérateur. La face avant 19 du chariot 18 porte le clavier alpha-numérique 11 et le système d'affichage 12. Au-dessus et au-dessous des bords longitudinaux de l'ouverture 17, sont fixés des rateliers 20 et 21 solidaires du bâti 15 et pourvus d'encoches 22 dans lesquelles peuvent pénétrer des câbles 23 à brancher.

Par ailleurs, dans la face avant 19 du chariot 18 est prévue une ouverture 24 (voir également la figure 3) dans laquelle peut être introduite le tiroir 9. Des organes de guidage et de coulissement 25 permettent d'introduire et de sortir le tiroir 9 par rapport au chariot 18. A l'intérieur du tiroir 9 est monté un faisceau 26 de fibres optiques s'étendant du fond 27 dudit tiroir, où leur répartition correspond à celle des voyants lumineux 8 de la matrice 7, à une paroi avant 28, où leur répartition correspond à celle des logements des broches d'une prise 10 à brancher. Les voyants lumineux 8 de la matrice 7 sont fixés sur le fond 29 du chariot 18 et, lorsque le tiroir 9 est mis en place dans le chariot 18, c'est-à-dire lorsque la face avant 30 du tiroir 9 est en appui contre la face avant 19 dudit chariot 18, l'extrémité de chacune des fibres optiques du faisceau 26 se trouve, du côté du fond 27, en regard d'un voyant lumineux 8 de la matrice 7. De plus, lorsqu'une prise ou autre élément 10 à brancher est fixé (de toute manière désirée) sur la face avant 30 du tiroir 9, l'extrémité de chacune des fibres optiques du faisceau 26 se trouve, du côté de la paroi avant 28, en regard d'un logement de broche de ladite prise ou élément 10. Le faisceau 26 du tiroir 9 établit donc une liaison lumineuse entre les voyants 8 et les logements des éléments 10 à brancher. Ainsi, la matrice 7 des voyants lumineux 8 commandés par le calculateur central 1 à travers le dispositif d'interface 6 peut être fixe et identique pour tous les éléments 10. En revanche, un tiroir 9 est associé à chaque modèle d'élément 10, c'est-à-dire que la répartition des extrémités des fibres optiques 26 au niveau de la paroi 28 est spécifique d'un élément 10 à brancher. L'opérateur choisit le tiroir 9 en fonction du modèle de l'élément 10 à câbler.

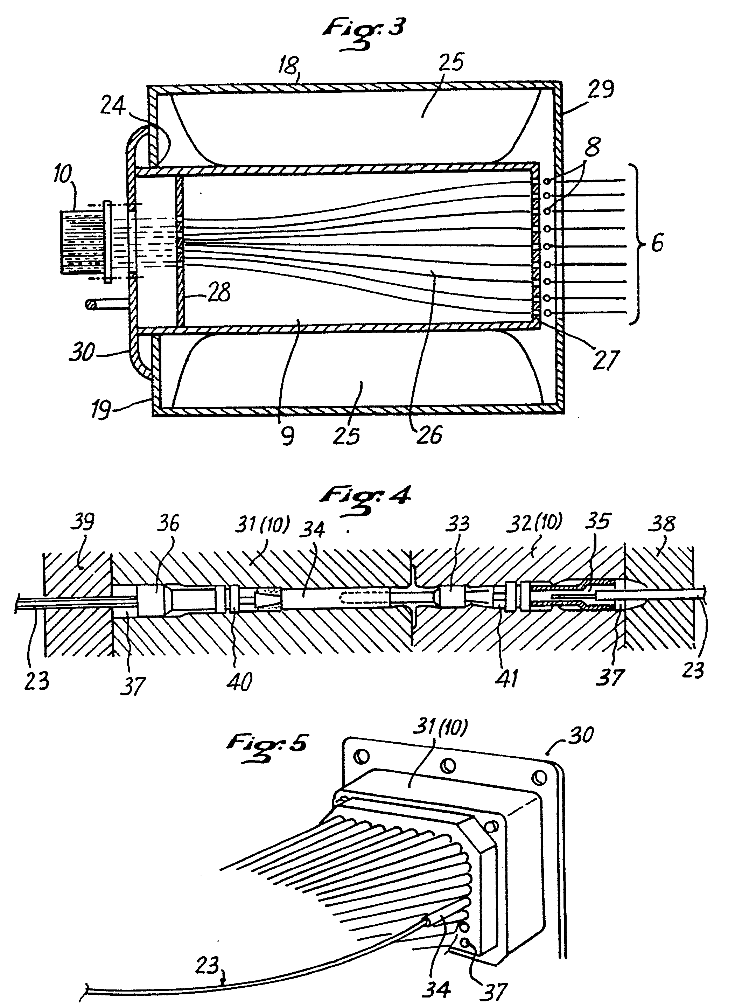

Sur la figure 4, on a représenté, en coupe schématique partielle, un connecteur, de type connu, pourvu de broches mâles et de broches femelles et dont chacune des deux parties 31 et 32 (chacune pouvant être considérée comme un élément 10) peut être câblée par l'installation conforme à l'invention.

Chaque broche mâle 33 ou femelle 34 du connecteur est sertie à l'extrémité d'un câble dénudé 23 par l'intermédiaire d'un manchon de sertissage 35 ou 36 et ces broches sont encliquetées dans les logements 37 prévus dans les corps de la partie mâle 32 et de la partie femelle 31 du connecteur complet.

Des zones d'étanchéité 38 et 39 peuvent compléter le connecteur, et on peut prévoir un système de verrouillage de broche 40 ou 41 qui assure la fixation de chaque broche en évitant son extraction accidentelle.

Quoi qu'il en soit, avant câblage, les logements 37 de la partie femelle 31 et de la partie mâle 32 sont vides et l'opérateur peut donc voir l'extrémité avant des fibres optiques 26 à travers lesdits logements.

Lorsque l'opérateur désire réaliser une pièce de câblage comprenant la prise 10 (par exemple l'une de celles montrées par les références 31 et 32 sur la figure 4), il commence par choisir le tiroir 9 approprié et il fixe cette prise 10, sur la face avant 30 dudit tiroir, à l'endroit prévu à cet effet. De plus, il introduit le tiroir 9 dans le chariot 18 de son poste de travail $P_i$.

Grâce au clavier alpha-numérique 11 du poste $P_i$, l'opérateur peut accéder aux informations concernant la pièce de câblage qu'il veut réaliser et contenues dans la mémoire de masse 2. Il introduit alors les codes de la prise ou barrette 10 et d'un câble 23 qu'il désire relier. En retour, le calculateur central 1 allume le voyant 8 correspondant, de sorte que l'opérateur voit s'allumer l'intérieur du logement 37 correspondant. L'opérateur place à l'extrémité dénudée dudit câble 23 la broche correspondante 33 ou 34 (voir la figure 5) et il introduit cette broche dans le logement 37 allumé.

De plus, le calculateur central 1 affiche sur le dispositif 12 le cheminement du câble 23 considéré, de sorte que l'opérateur peut introduire celui-ci dans l'encoche correspondante 22 du ratelier 20 ou 21.

On voit donc que l'opérateur peut, sur les indications du calculateur central 1, relier de façon correcte tous les câbles 23 aboutissant à l'élément 10 et amorcer le cheminement desdits câbles à partir de cet élément 10.

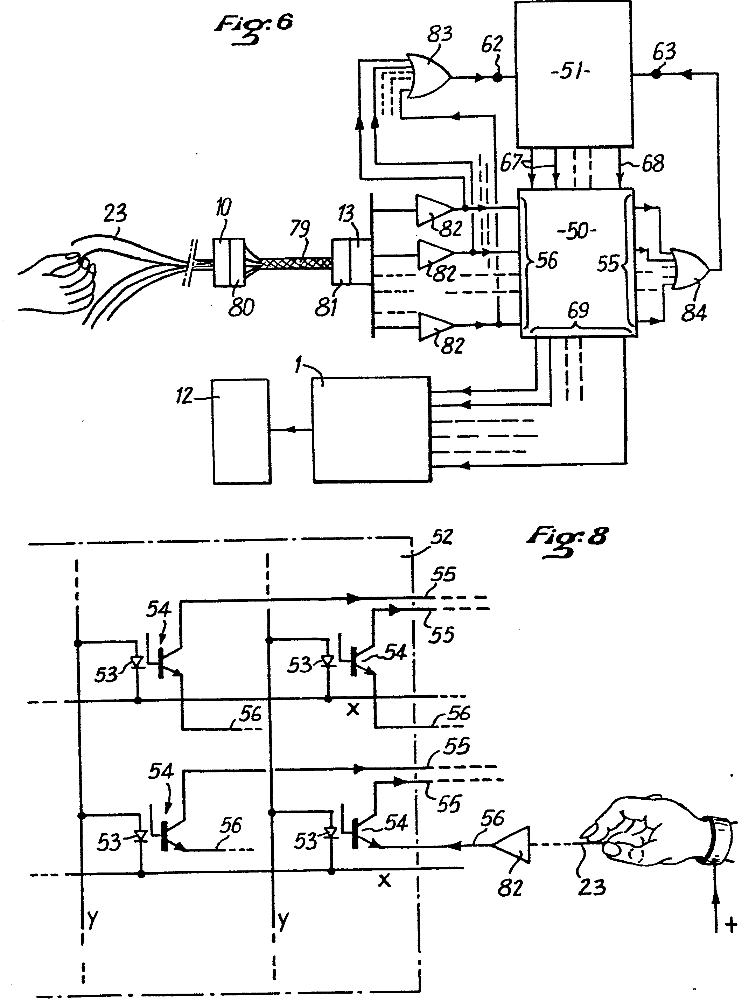

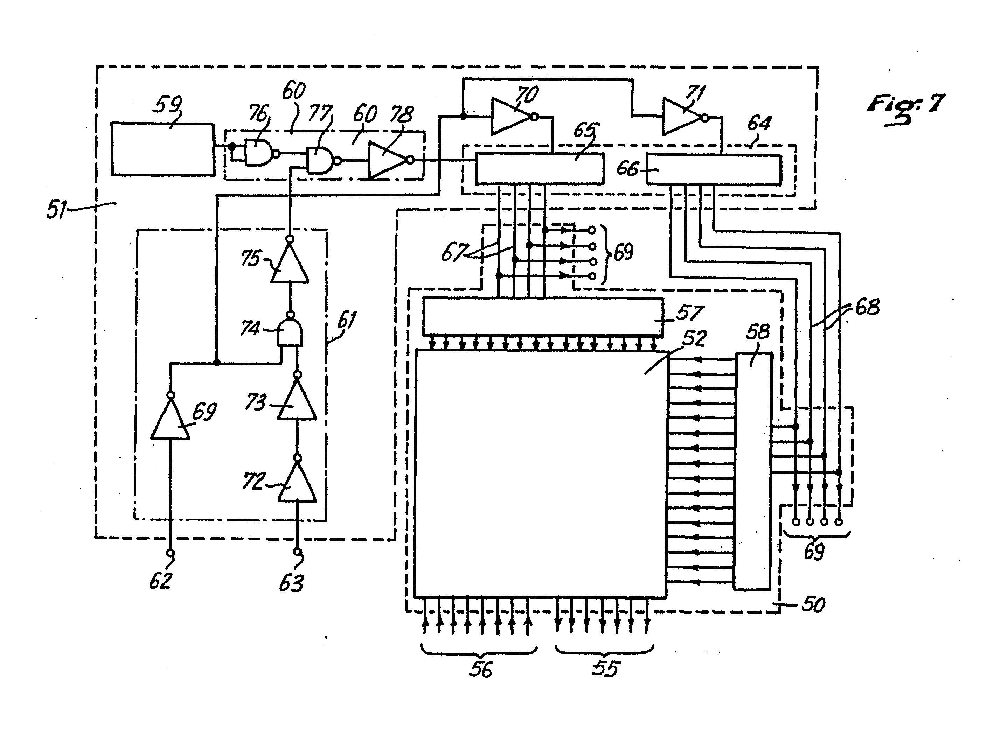

Lorsque l'opérateur veut connecter l'extrémité encore non branchée d'un câble 23, dont l'autre extrémité est déjà reliée audit élément 10, il peut recommencer une procédure analogue à celle qui vient d'être décrite ci-dessus. Cependant, la présente invention prévoit un processus par touches sensitives beaucoup plus rapide, illustré par les figures 6, 7 et 8.

Pour pouvoir mettre en oeuvre ce processus, on prévoit un encodeur de position constitué, d'une part, d'un système matriciel 50 et, d'autre part, d'un système de commande 51 dudit système matriciel.

Le système matriciel 50 comporte une matrice 52 de conducteurs disposés en lignes X et en colonnes Y (voir également la figure 8) et, à chaque intersection d'une ligne X et d'une colonne Y, est connectée la diode de commande 53 de coupleurs optiques 54. Les collecteurs desdits coupleurs optiques 54 sont réunis à des bornes de sortie 55 de ladite matrice 52, tandis que les émetteurs desdits coupleurs optiques 54 forment des bornes d'entrée 56 pour celle-ci. De plus, le système matriciel 50 comporte deux décodeurs 57 et 58 qui commandent respectivement les colonnes Y et les lignes X de la matrice 52.

Le sytème de commande 51 comporte un multivibrateur astable 59, dont le train d'impulsions peut être bloqué par un système de blocage 60, lui-même commandé par une commande 61, à deux entrées 62 et 63. Le système de commande 51 comporte de plus un dispositif de comptage 64, constitué de deux compteurs 65 et 66, actionnant respectivement les décodeurs 57 et 58 du système matriciel 50, grâce aux liaisons 67 et 68, qui par ailleurs forment des sorties 69 dudit système matriciel 50, reliées au calculateur 1. Le système de blocage 60 et la commande 61 comporte un ensemble de portes logiques 69 et 72 à 78 associées à deux portes 70 et 71 de commande des compteurs 65 et 66.

Comme on peut le voir sur la figure 6, les sorties 55 du système matriciel 50 sont reliées à l'entrée 63 du système de commande 51, par l'intermédiaire d'une porte logique OU 84.

Par ailleurs, l'extrémité dénudée d'un conducteur 23, susceptible d'être touchée par la main de l'opérateur (éventuellement reliée à un point de potentiel déterminé par un bracelet - voir figure 8 -) est en liaison avec une entrée 56 du système matriciel 50, par l'intermediaire de l'élément 10, d'un faisceau-outillage d'interface 79 à connecteurs d'extrémité 80 et 81, d'un connecteur 13 et d'un amplificateur 82. De plus, les sorties des amplificateurs 82 sont reliées par une porte logique OU 83 à l'entrée 62 du système de commande 51.

Le fonctionnement du dispositif des figures 6 à 8 est le suivant.

Dès la mise sous tension, le multivibrateur 59 fonctionne.

Toutefois, au repos, l'entrée 63 est au niveau logique 1, de sorte que, par l'action des deux portes PAS 72 et 73, l'entrée correspondante de la porte NON ET 74 est validée. De plus, au repos, l'entrée 62 est également au niveau logique 1, de sorte qu'à cause de la porte PAS 69, l'autre entrée de la porte NON ET 74 est invalidée. La porte NON ET 77 est donc également invalidée et le signal du multivibrateur 59 est bloqué.

Lorsque l'opérateur touche l'extrémité d'un conducteur 23 non reliée à l'élément 10, il applique un niveau logique 0, d'une part, sur l'entrée 62, d'autre part sur la sortie 55 correspondante de la matrice 52.

Ce niveau logique 0 appliqué sur l'entrée 62 a pour effet de remettre à zéro et de valider les compteurs 65 et 66 par l'intermédiaire des portes 70 et 71. Par ailleurs, grâce à la porte 69, un niveau 1 est appliquè sur l'entrée correspondante de la porte NON ET 74.

Par suite, en supposant que l'entrée 63 reçoit toujours un niveau logique 1, le signal de sortie de la porte NON ET 74 valide la porte NON ET 77 et le signal du multivibrateur 59 est débloqué et parvient jusqu'aux compteurs 65 et 66. Ceux-ci se mettent à fonctionner et permettent d'explorer pas-à-pas l'état électrique de chaque point de la matrice 52. Tant que, au cours de cette exploration, on examine des points de la matrice 52 non électriquement reliés à la main de l'opérateur, la sortie 55 correspondante adresse à l'entrée 63, par l'intermédiaire de la porte OU 84 un niveau logique 1. Par suite, le fonctionnement des compteurs 65 et 66 se poursuit, faisant passer d'un point de la matrice au suivant.

En revanche, lorsque, au cours de leur exploration, les compteurs 65 et 66 atteignent le point de matrice 52 relié électriquement à la main de l'opérateur, il apparaît un niveau logique 0 à la sortie 55 correspondante et donc à l'entrée 63. La porte NON ET 74 se bloque donc, de sorte qu'il en est de même de la porte NON ET 77. Les compteurs 65 et 66 ne reçoivent plus les impulsions du multivibrateur astable 59.

Par les sorties 69, le calculateur 1 connaît donc l'adresse du point de la matrice 52 à laquelle les compteurs 65 et 66 s'arrêtent de fonctionner, c'est-à-dire qu'il identifie le conducteur 23 touché par l'opérateur. Il peut donc indiquer à celui-ci, par l'intermédiaire des moyens d'affichage 12, la destination de l'extrémité non branchée dudit conducteur 23.

**Revendications**

1 - Système destiné à la réalisation de pièces de câblage électrique, dans lesquelles chaque conducteur (23) relie deux dispositifs de raccordement (10) dont chaque emplacement de connexion d'au moins l'un d'eux est transparent, et comportant un calculateur (1) associé à une memoire de masse (2) dans laquelle sont emmagasinées des informations concernant l'identification des conducteurs, les adresses des extrémités de ceux-ci, ainsi que le cheminement de chacun desdits conducteurs, ledit système comportant au moins un poste de travail ($P_1$, $P_2$,.....) pour un opérateur, en liaison avec ledit calculateur et avec ladite mémoire de masse, et ledit poste de travail comportant des moyens d'introduction de données (11) et un ensemble (7) de points lumineux (8) commandables sélectivement et disposés selon une répartition semblable à celle desdits emplacements de connexion transparents dudit dispositif de raccordement, chaque poste de travail (P1, P2...) comportant des moyens d'affichage (12),
caractérisé en ce que les moyens d'introduction de données (11), l'ensemble (7) de points lumineux commandables (8), le dispositif de raccordement (10) à connecter et lesdits moyens d'affichage (12) sont solidaires d'un organe mobile (18) pouvant se déplacer le long d'au moins un ratelier (20, 21) pourvu d'encoches (22) pour les conducteurs (23) de la pièce de câblage et supporté par le bâti (15, 16) dudit poste de travail.

2 - Système selon la revendication 1, caractérisé en ce que l'ensemble de points lumineux commandable comporte une matrice unique (7) de points lumineux commandables (8) et une pluralité de faisceaux de fibres optiques (26) interchangeables, chacun desdits faisceaux étant adapté à un modèle particulier de dispositif de raccordement (10) et étant composé de fibres optiques, qui, à une de leurs extrémités, se trouvent en regard d'au moins certains desdits points lumineux commandables (8) et, à leur autre extrémité, se trouvent en regard des emplacements de connexion transparents dudit modèle particulier du dispositif de raccordement (10), auquel il est adapté, et en ce que chacun desdits faisceaux de fibres optiques (26) est monté, en vue de la facilité de son interchangeabilité avec les autres, dans un organe amovible (9) présentant la forme d'un tiroir pouvant être mis en place dans l'organe mobile (18) et sorti de celui-ci, par simple coulissement.

3 - Système selon l'une des revendications 1 ou 2, caractérisé en ce que chaque poste de travail (P1, P2,...) comporte de plus au moins un organe de connexion (13), qui, d'une part, est susceptible d'être réuni à un dispositif de raccordement (10) auquel sont déjà reliées les extrémités de certains conducteurs (23) et, d'autre part, est en liaison avec un dispositif de détection (50, 51) susceptible d'indiquer au calculateur (1) celui desdits conducteurs (23) de la pièce de câblage dont l'extrémité opposée au dispositif de raccordement (10) est touchée par l'opérateur.

4 - Système selon la revendication 3, caractérisé en ce qu'il comporte une pluralité de faisceaux d'outillage (79), susceptibles d'être interposés entre ledit dispositif de raccordement (10) d'une pièce de câblage et ledit organe de connexion (13).

5 - Système selon la revendication 3, caractérisé en ce que ledit dispositif de détection comporte une matrice (52) de points commandables pouvant prendre au moins deux états électriques différents et chacun en liaison avec un conducteur (23), un dispositif (59, 64) d'exploration de l'état desdits points commandables de ladite matrice (52) et un dispositif de commande (60, 61) dudit dispositif d'exploration (59, 64).

6 - Système selon la revendication 5, caractérisé en ce que ladite matrice (52) est du type à coupleurs optiques (53, 54) tandis que le dispositif d'exploration (59, 64) comporte un multivibrateur astable (59).

7 - Système selon l'une des revendications 1 à 6, caractérisé en ce que chaque poste de travail (P1, P2,...) comporte de plus un magasin (14) divisé en une pluralité de cases dont chacune est identifiable par le calculateur et contient un conducteur non identifié.

**Patentansprüche**

1. System zur Herstellung von elektrischen Verdrahtungen oder Leitungsführungen, bei denen jeder Leiter (23) an zwei Anschlußvorrichtungen (10) liegt, deren jede Verbindungstelle zumindest einer von beiden durchsichtig ist, und bestehend aus einem Rechner (1), der einem Massespeicher (2) zugeordnet ist, in dem die der Identifizierung der Leiter dienenden Daten, die Adressen von deren Endanschlüssen sowie der Verlauf jedes Leiters eingespeichert sind, und aus zumindest einem Arbeitsplatz (P1, P2,...) für eine Bedienungsperson, der mit dem Rechner und dem Massespeicher verbunden ist und der über eine Dateneingabe (11) sowie eine Gesamtheit (7) von Leuchtpunkten (8) verfügt, die selektiv angesteuert werden können und so aufgeteilt angeordnet sind, daß sie den durchsichtigen Verbindungsstellen der Anschlußvorrichtung entsprechen, wobei jeder Arbeitsplatz (P1, P2,...) Datenanzeige-Einrichtungen (12) aufweist,
dadurch gekennzeichnet,
daß die Dateneingabe-Einrichtungen (11), die Gesamtheit (7) der ansteuerbaren Leuchtpunkte (8), die anzuschliessende Anschlußvorrichtung (10) und die Datenanzeige-Einrichtungen (12) an einem beweglichen Teil (18) liegen, das sich längs zumindest eines Einsteckgatters (20, 21) verschieben kann, das mit Ausklinkungen (22) für jeden Leiter (23) der Verdrahtung oder Leitungsführung versehen ist und von dem Gestell (15, 16) des Arbeitsplatzes getragen wird.

2. System nach Anspruch 1,
dadurch gekennzeichnet,
daß die Gesamtheit der ansteuerbaren Leuchtpunkte eine alleinige Matrix (7) der ansteuerbaren Leuchtpunkte (8) sowie mehrere miteinander austauschbare Faserbündel (26) aufweist, von denen jedes einer besonderen Ausführungsform der Anschlußvorrichtung (10) angepaßt ist und aus optischen Fasern besteht, die an einem ihrer Enden zumindest bestimmten ansteuerbaren Leuchtpunkten (8) gegenüberliegen und die an ihren anderen Enden den durchsichtigen Verbindungsstellen der besonderen Ausführungsform der Anschlußvorrichtung (10) gegenüberliegen, der sie angepaßt ist, und daß jedes optische Faserbündel (26) im Hinblick auf die Austauschfähigkeit miteinander in einem abnehmbaren Teil (9) angeordnet ist das schubfachartig ausgebildet ist und in das bewegliche Teil (18) eingesetzt und durch einfache Gleitbewegung aus ihm herausgeführt werden kann.

3. System nach einem der vorhergehenden Ansprüche 1 oder 2,
dadurch gekennzeichnet,
daß jeder Arbeitsplatz (P1, P2,...) darüberhinaus zumindest eine Anschlußeinrichtung (13) besitzt, die einerseits an die Anschlußvorrichtung (10) angeschlossen werden kann, an der bereits die Enden der bestimmten Leiter (23) liegen, und andererseits mit einer Prüfeinrichtung (50, 51) verbunden ist, durch die dem Rechner (1) derjenigen Leiter (23) der Verdrahtung oder Leitungsführung angezeigt werden kann, dessen Ende, das der Anschlußvorrichtung (10) gegenüberliegt, von der Bedienungsperson berührt wird.

4. System nach Anspruch 3,
gekennzeichnet durch
eine Vielzahl von Verarbeitungsbündeln (79), die zwischen die Anschlußvorrichtung (10) einer Verdrahtung oder Leitungsführung und der Anschlußeinrichtung (13) eingefügt werden können.

5. System nach A spruch 3,
dadurch gekennzeichnet,
daß die Prüfvorrichtung eine Matrix (52) der ansteuerbaren Punkte, die zumindest zwei unterschiedliche elektrische Zustände annehmen können und von denen jeder an einem Leiter (23) liegt, eine Abtastvorrichtung (59, 64) zum Feststellen des Zustandes der ansteuerbaren Punkte der Matrix (52) und eine Steuerung (60, 61) für die Abtastvorrichtung (59, 64) aufweist.

6. System nach Anspruch 5,
dadurch gekennzeichnet,
daß die Matrix (52) als optischer Koppler (53, 54) ausgebildet ist, während die Abtastvorrichtung (59, 64) einen astabilen Multivibrator (59) aufweist.

7. System nach einem der vorhergehenden Ansprüche 1 bis 6,
dadurch gekennzeichnet,
daß jeder Arbeitsplatz (P1, P2,...) darüberhinaus ein Magazin (14) aufweist, das in mehrere Fächer unterteilt ist, von denen ein jedes vom Rechner identifiziert werden kann und einen nicht identifizierten Leiter enthält.


**Claims**

1.- System designed for producing electrical wiring parts in which each conductor (23) connects two connection devices (10), each connection location of at least one of them being transparent, and comprising a computer (1) associated to a bulk memory (2) in which are stored data concerning the identification of the conductors, the addresses of their ends and the travel of each of said conductors, said system comprising at least one work station (P1, P2,...) for an operator, which work station is linked with said computer and said bulk memory, and said work station comprising data input means (11) and a set (7) of selectively controllable light points (8) disposed according to a distribution similar to that of said transparent connection locations of said connection device, each work station (P1, P2,...) comprising display means (12), characterized in that the data input means (11), the set (7) of controllable light points (8), the connection device (10) to be connected and said display means (12) are integral with a movable member (18) which is displaceable along at least one rack (20, 21) provided with notches (22) to receive the conductors (23) of the wiring part and supported by the frame (15, 16) of said work station.

2.- System according to claim 1,
characterized in that the set of controllable light points comprises a single matrix (7) of controllable light points (8) and a plurality of bundles of interchangeable optical fibers (26), each of said bundles being adapted to a particular type of connection device (10) and being composed of optical fibers which, at one of their ends, are facing at least some of said controllable light points (8) and, at their other end, are facing the transparent connection locations of said particular type of said connection device (10) to which it is adapted, and in that each of said bundles of optical fibers (26) is mounted, in order to facilitate its interchangeability with the others, in a removable member (9) in the form of a sliding unit which can be introduced into said movable member (18) and removed therefrom by simple sliding.

3.- System as claimed in claim 2,
characterized in that each work station (P1, P2,...) further comprises at least one connection member (13) which, on the one hand, can be connected with a connection device (10) to which are already connected the ends of certain conductors (23), and, on the other hand, is connected with a detection device (50, 51) adapted to indicate to the computer (1) which of said conductors (23) of the wiring part is being touched by the operator at its end opposite said connection device (10).

4.- System as claimed in claim 3,
characterized in that it comprises a plurality of bundles of aids (79) adapted to be interposed between said connection device (10) of a wiring part and said connection member (13).

5.- System as claimed in claim 3,
characterized in that said detection device comprises a matrix (52) of controllable points capable of taking at least two different electrical states, each point being connected with a conductor (23), means (59, 64) for scanning the state of said controllable points of said matrix (52), and means (60, 61) for controlling said scanning device (59, 64).

6.- System as claimed in claim 5, characterized in that said matrix (52) is of the type with optical couplers (53, 54) whereas the scanning device (59, 64) comprises an astable multivibrator (59).

7.- System as claimed in any of claims 1 to 6, characterized in that every work station (P1, P2,...) further comprises a magazine (14) divided into a plurality of compartments each compartment being identifiable by the computer and containing a non-identified conductor.

Fig.1

Fig. 2

0 124 412

*Fig. 3*

*Fig. 4*

*Fig. 5*

0 124 412

**Fig: 6**

**Fig: 8**

7

Fig. 7

0 124 412